Europäisches Patentamt

(19) European Patent Office

Office européen des brevets

(11) Numéro de publication : **0 029 919**
**B1**

(12) # FASCICULE DE BREVET EUROPÉEN

(45) Date de publication du fascicule du brevet :
**05.10.83**

(51) Int. Cl.³ : **H 03 K 19/00**, H 03 K 17/08, H 03 K 5/02

(21) Numéro de dépôt : **80106634.1**

(22) Date de dépôt : **29.10.80**

(54) **Circuit d'interface conforme aux normes EIA RS 232C réalisé à partir d'un amplificateur opérationnel.**

(30) Priorité : **28.11.79 FR 7929808**

(43) Date de publication de la demande :
**10.06.81 Bulletin 81/23**

(45) Mention de la délivrance du brevet :
**05.10.83 Bulletin 83/40**

(84) Etats contractants désignés :
**DE FR GB**

(56) Documents cités :
**DE A 2 307 540**
**DE A 2 515 615**
**FR A 2 146 091**
**FR A 2 363 215**
**US A 3 757 138**

**ELECTRONICS, vol. 47, no. 3, 7 février 1974 New York US DOBKIN : « IC with load protection simulates power transistor », pages 119-123**

**IBM TECHNICAL DISCLOSURE BULLETIN, vol. 20, no 1, juin 1977, New York US MYERS : « EIA Level Cable Driver », pages 319-320**

(73) Titulaire : **International Business Machines Corporation**
**Old Orchard Road**
**Armonk, N.Y. 10504 (US)**

(72) Inventeur : **Delaporte, François Xavier**
**36, Chemin de Saint-Laurent**
**F-06170 Cros de Cagnes (FR)**
Inventeur : **Lebesnerais, Gérard Maxime**
**9, rue des Près**
**Saint Germain sur Ecole F-77930 Perthes (FR)**
Inventeur : **Pantani, Jean-Pierre**
**239, Boulevard du Mont Boron - B5**
**F-06300 Nice (FR)**

(74) Mandataire : **Klein, Daniel**
**COMPAGNIE IBM FRANCE Département de Propriété Industrielle**
**F-06610 La Gaude (FR)**

Jouve, 18, rue St-Denis, 75001 Paris, France

Circuit d'interface conforme aux normes EIA RS 232C réalisé à partir d'un amplificateur opérationnel

## Description

### Domaine Technique

La présente invention concerne le domaine des circuits d'interface, c'est-à-dire qui définissent les échanges de signaux binaires entre deux équipements informatiques ; elle concerne plus particulièrement des circuits d'interface conformes aux normes internationales notamment EIA RS 232C ou CCITT V24. C'est grâce à l'existence de ces normes, acceptées par tous les constructeurs que les équipements d'origine différente peuvent être interconnectés. Ces circuits d'interface ont donc un rôle capital et leur utilisation fréquente : en particulier entre un terminal et un modem, une série de modems et un concentrateur téléphonique, etc.

Ces normes EIA définissent les procédures d'échange et les caractéristiques électriques des signaux binaires (tensions, impédances, ...).

De façon plus détaillée, ces signaux binaires ont la particularité d'être différents des signaux binaires utilisés à l'intérieur des machines, et ne sont liés à aucune technologie : TTL, ECL, ... Ils se définissent ainsi :

1) Les niveaux : la plage positive est comprise dans la gamme + 5 à + 15 volts, la plage négative est comprise dans la gamme de − 5 à − 15 volts ; entre ces deux plages (ce qui inclut le 0 volt) se trouve la plage interdite.

2) L'impédance d'entrée des récepteurs doit être résistive avec 3 k$\Omega$ ≤ R ≤ 7 k$\Omega$.

3) La pente doit être contrôlée. La tension de sortie lors des transitions entre l'état haut et l'état bas doit varier à une vitesse bien définie comprise entre un minimum et un maximum très étroitement spécifiés, ceci pour permettre une cadence de signaux suffisamment élevée et cependant éviter les phénomènes connus de diaphonie que produiraient des flancs trop raides. Cette pente $\Delta v/\Delta t$ du signal de sortie devra être relativement indépendante (dans certaines limites) de la charge appliquée sur la sortie.

4) Le circuit d'interface doit supporter un court-circuit accidentel à une tension quelconque comprise entre + 15 volts et − 15 volts.

5) Surtension : la machine dans laquelle sont montés de tels circuits d'interface n'étant pas alimentée, le circuit d'interface doit supporter une tension appliquée sur sa sortie de l'extérieur, et comprise entre − 15 volts et + 15 volts, ce quel que soit l'état logique des entrées, et que le circuit soit sous tension ou non. L'application d'une telle tension ne doit pas occasionner des courants de court-circuits ou des échauffements excessifs, ou causer la destruction du circuit ou des cellules de liaison.

6) A la mise sous tension de la machine, des moyens seront prévus, pour qu'aucun signal parasite ne soit transmis en sortie. Accessoirement un état haute impédance sera possible pour permettre les applications en parallèle (mode dit : tristate).

7) Lorsque la machine n'est pas sous-tension les sorties doivent présenter une impédance au moins égale à 300 $\Omega$.

### Etat de la Technique

De nombreux exemples de circuits d'interface existent dans le commerce. Ce sont des circuits spécifiques, relativement simples et bon marché mais qui présentent généralement des inconvénients importants, parmi eux, on peut citer :

1) La faible densité : souvent deux circuits d'interface par module.

2) La nécessité d'utiliser des composants extérieurs s'il s'agit de circuits intégrés en ce qui concerne des fonctions annexes : contrôle du flanc de montée (par une capacité), de protection contre d'éventuelles surtensions (par des diodes), suppression des parasites à la mise sous-tension.

3) La nécessité d'utiliser de fortes tensions d'alimentation : ces circuits sont compatibles seulement avec des tensions d'alimentation élevées $/V_{CC}/ > 12V$, alors que la tendance actuelle est d'évoluer vers des tensions d'alimentation plus faibles (par exemple 8V), ce qui est avantageux pour la consommation électrique, et la dissipation thermique, mais apparaît difficile à mettre en œuvre quand on sait que pour être conformes les signaux doivent être compris entre 5V et 15V. En d'autres termes la tension de déchet devra être aussi réduite que possible.

4) La nécessité de mettre en œuvre une séquence particulière pour la mise sous tension.

5) Ces circuits ne fournissent que de faibles courants de sortie, insuffisants pour commander de longs câbles de sortie.

On pourra trouver dans le Texas Handbook (pages 3149 et 3150, édition 1978) la description d'un circuit d'interface (line driver) et ses caractéristiques. On remarquera que ce circuit n'est pas compatible avec toutes les technologies (par exemple ECL), que la limitation de fréquence (slew rate) s'effectue par une capacité extérieure, ce qui nécessite une adaptation pour chaque cas particulier (ligne, client, ...). Il nécessite des tensions d'alimentation élevées (± 12V), et ne peut fonctionner en « tristate ». Enfin c'est un circuit qui consomme beaucoup de courant.

### Exposé de l'Invention

Un premier objet de l'invention consiste dans la réalisation d'un circuit d'interface conforme au cahier des charges de la norme EIA 232C (CCITT V24 et V28) dont les caractéristiques ont été énoncées ci-dessus.

Un autre objet de l'invention consiste dans la réalisation d'un circuit d'interface numérique bon marché à forte densité d'intégration et monolithique, c'est-à-dire sans composants extérieurs, ni réglage, susceptible d'être réalisé dans toute technologie bipolaire classique avec des rendements de fabrication élevés.

Encore un autre objet de l'invention consiste dans la réalisation d'un circuit d'interface numérique qui s'adapte à tous les circuits quelle que soit leur technologie (TTL, ECL, etc.) et qui fonctionne avec des tensions d'alimentation $\pm V_{CC}$ relativement basses.

Encore un autre objet de l'invention consiste dans la réalisation d'un circuit d'interface numérique qui puisse fournir un courant de sortie important (10-20mA) sur les lignes capacitives.

La présente invention qui sera décrite en détail ci-après est essentiellement fondée sur l'idée d'adapter un amplificateur opérationnel à la fonction spécifique de circuit d'interface numérique. La transposition d'un amplificateur opérationnel couramment (mais exclusivement) utilisé dans des applications analogiques, comme circuit d'interface logique comme proposé ici n'apparaît pas évidente. Cependant elle apparaît susceptible de présenter des points positifs très intéressants qui seront détaillés ci-après. Enfin les amplificateurs opérationnels sont des circuits bien connus très largement utilisés dans l'industrie électronique, hautement perfectionnés, très intégrés, par conséquent consommant peu ; il est donc avantageux de garder la structure de base d'un amplificateur opérationnel et de lui apporter les modifications nécessaires pour le transformer en circuit d'interface, qui devient alors performant, bon marché et à haute densité d'intégration.

La présente invention telle qu'elle est caractérisée dans les revendications résout les inconvénients posés pour les circuits d'interface de l'art antérieur.

Un mode de réalisation préféré de la présente invention sera décrit en référence aux dessins annexés à ce texte.

Brève description des figures

La figure 1 montre le schéma synoptique ou bloc diagramme d'un amplificateur opérationnel classique de l'art antérieur qui met en évidence les différentes fonctions consécutives.

La figure 2 montre la réalisation pratique d'un amplificateur opérationnel, sous forme de circuit électrique tel qu'il pourrait être réalisé dans une technologie bipolaire à transistors complémentaires PNP + NPN.

La figure 3 montre le schéma synoptique de l'amplificateur opérationnel représenté sur la figure 1 auquel on a apporté un certain nombre de modifications pour que le circuit puisse fonctionner en circuit d'interface conforme aux normes EIA.

La figure 4 montre la réalisation pratique du circuit d'interface tel qu'il pourrait être réalisé dans une technologie bipolaire à transistors complémentaires NPN + PNP.

La figure 5 montre le détail dans la structure du circuit de protection XI montré sur la figure 3, des moyens de protection avec leurs dispositifs parasites associés.

Description de l'invention

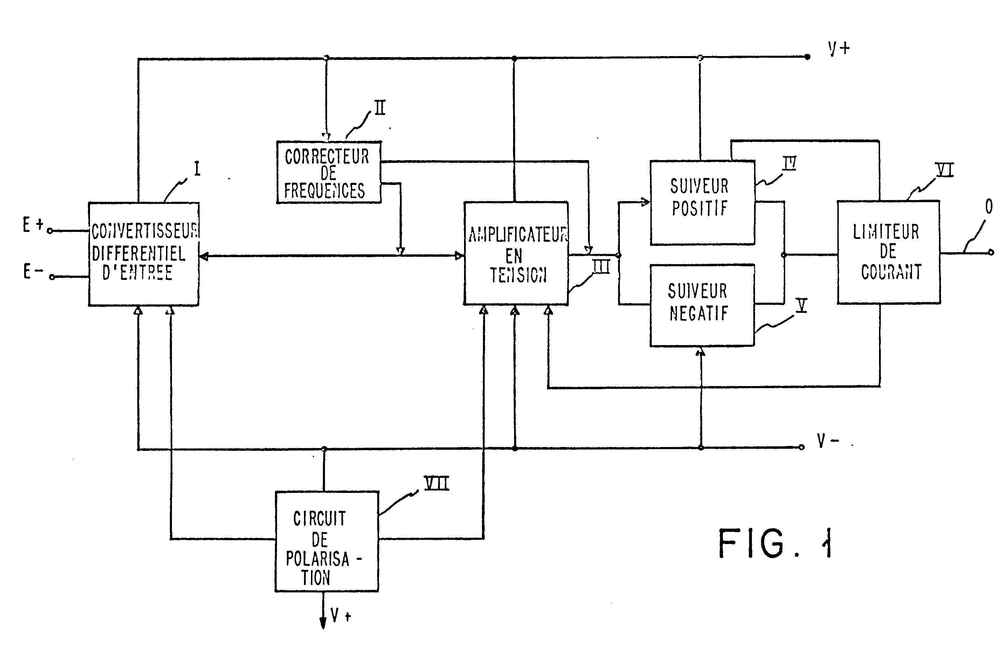

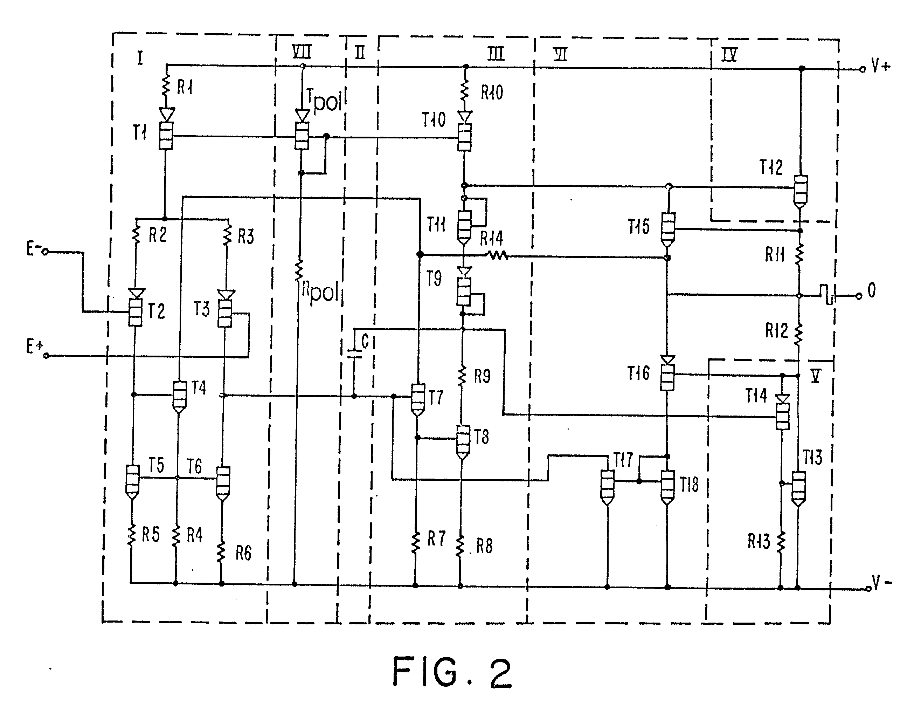

Les figures 1 et 2 montrent respectivement le bloc diagramme d'un amplificateur opérationnel de la technique antérieure mettant en évidence les fonctions élémentaires et son schéma de réalisation sous forme de circuit électrique.

De façon bien connue, un tel amplificateur opérationnel comporte un convertisseur différentiel d'entrée (I) muni de deux entrées E − et E + dont la sortie est couplée à un circuit correcteur de fréquence (II) ; après mise en forme le signal est amplifié en tension (III) et attaque deux circuits suiveurs positif (IV) et négatif (V), puis un circuit limiteur de courant (VI). Le signal de sortie est disponible sur la borne 0. L'ensemble du bloc est alimenté entre deux tensions symétriques d'alimentation V + et V −, il comprend en outre un dispositif de polarisation (VII) des blocs (I) et (III).

La figure 2 montre un exemple pratique de réalisation, on voit que le bloc correcteur de fréquence se réduit pratiquement à une capacité C.

Un amplificateur opérationnel très voisin est publié dans l'IBM Technical Disclosure Bulletin, Vol. 22, N° 2, juillet 1979, pages 610 et 611, dans un article de F. Delaporte et J. P. Pantani intitulé : « Antisaturation Circuit For an Operational Amplifier ». Les modifications portent sur le circuit d'entrée (suppression de T2, T3, T4, D27 et D28) et le circuit de polarisation (suppression de T8, T9 et T15).

L'utilisation d'un tel amplificateur opérationnel apporte d'abord les avantages suivants :

— L'existence de deux entrées différentielles E − et E + permet de relier une des entrées (E +) à une tension de référence $V_{REF}$, ce qui permet à l'amplificateur opérationnel d'accepter comme étage précédent, tout circuit quelle que soit la technologie (ECL, TTL, FET, ...), il suffit de choisir pour valeur de $V_{REF}$, la tension la plus appropriée à la technologie du circuit amont.

— Un courant d'entrée faible, ce qui contribue également à faciliter l'adaptation aux différentes technologies.

— L'impédance de sortie est également faible, grâce à la présence des étages suiveurs (IV et V).

— Il est muni d'un limitateur de courant (bloc VI) indispensable dans l'hypothèse où accidentellement la sortie 0 et la tension d'alimentation (V − ou V +) serait en court-circuit.

— Le contrôle de la pente : un amplificateur opérationnel est équipé d'un circuit correcteur de fréquence qui a pour but de rendre le circuit stable lorsqu'il est inséré dans une boucle fermée (contre-réaction). Ce circuit correcteur a pour effet secondaire de limiter la pente du signal de sortie. Ce qui est un inconvénient majeur pour un amplificateur opérationnel se trouve être un avantage majeur dans la présente invention. Alors que les constructeurs d'amplificateurs opérationnels s'efforcent de minimiser ce défaut, dans la présente invention les éléments électriques courants, tensions, résistances, capacités sont calculés de façon précise pour que les spécifications précitées soient satisfaites.

— Le contrôle de la polarisation : un amplificateur opérationnel est équipé d'un dispositif de polarisation qui a pour but de placer avec précision le circuit de sortie en classe AB.

Bien que ce ne soit pas l'objectif poursuivi, l'introduction d'un tel dispositif dans un amplificateur opérationnel a également pour effet de placer l'ensemble du circuit en haute impédance si cette polarisation était coupée.

Une des idées de base de la présente invention est donc de détourner de son but initial le dispositif de polarisation et de modifier le circuit pour rendre cette polarisation contrôlable à partir d'un circuit extérieur.

Ainsi, on aura la possibilité, lors de la mise sous-tension ou lors du fonctionnement en « tristate », de bloquer l'émission de signaux par ce circuit pendant tout le laps de temps souhaitable.

En regard cependant des avantages ci-dessus, un amplificateur opérationnel pris tel quel présenterait de graves inconvénients car il ne dispose pas de circuits de protection contre les surtensions susceptibles de se produire sur les lignes de transmission ou au cours des manipulations effectuées sur les machines et, non polarisé, il présenterait sur sa sortie une faible impédance incompatible avec les exigences des spécifications précitées.

Un amplificateur opérationnel classique ne pourrait donc en aucun cas satisfaire aux contraintes édictées par le cahier des charges de la norme EIA.

Description d'un mode préféré de réalisation

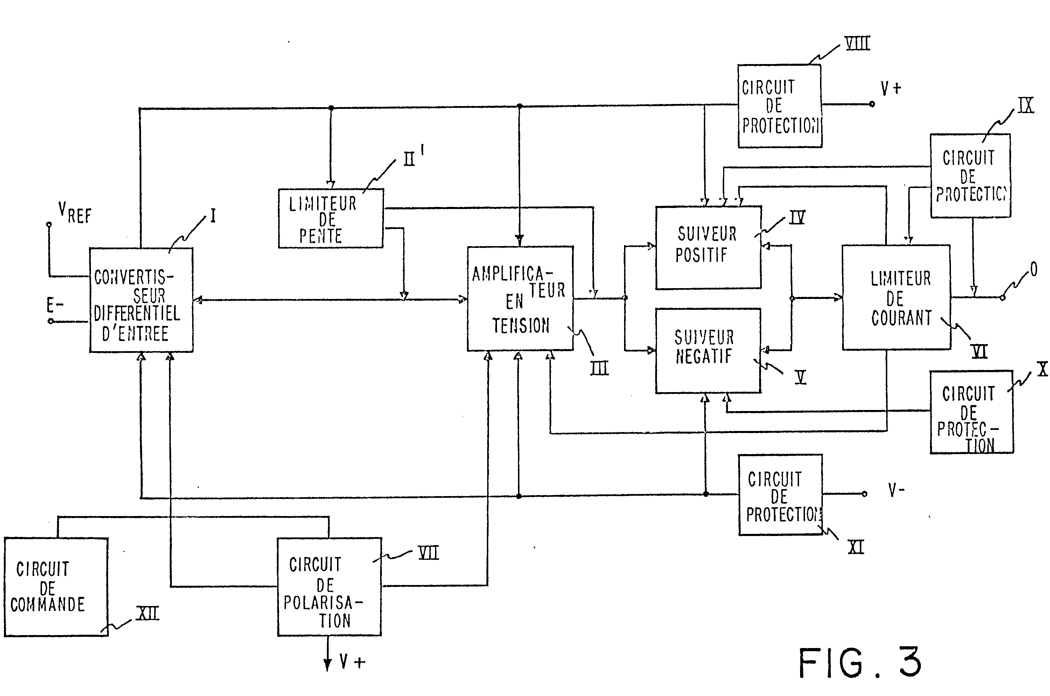

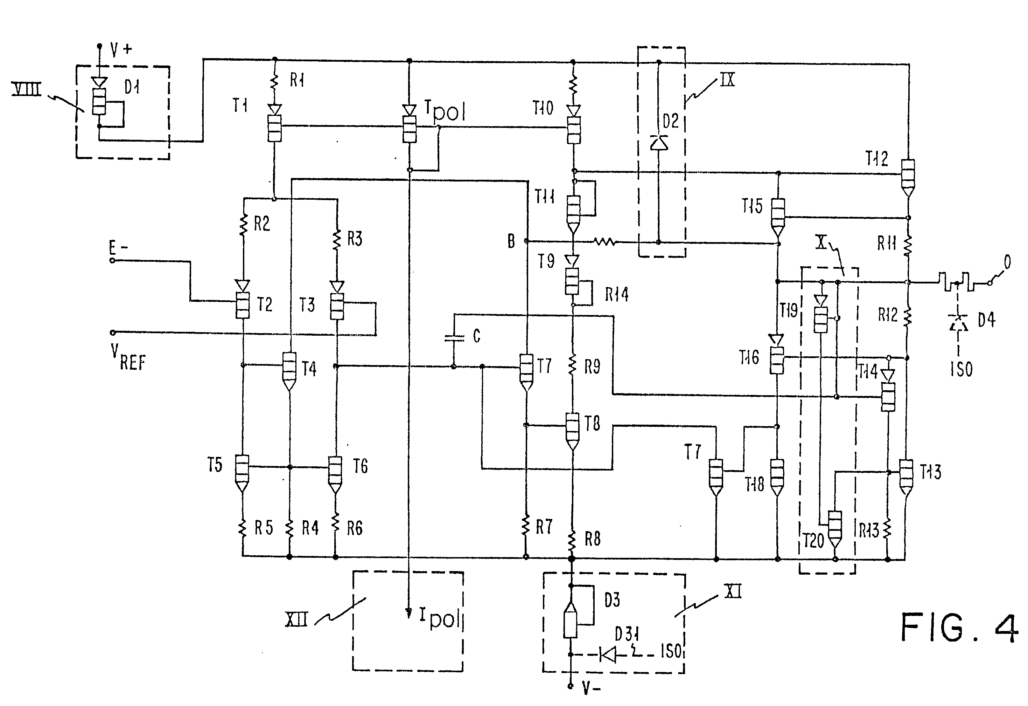

Un circuit d'interface intégré monolithique conforme aux normes EIA construit autour d'un amplificateur opérationnel modifié pour tenir compte desdites normes va être décrit ci-dessous en référence aux figures 3 et 4.

A. Protection contre les surtensions positives :

Le bloc VIII a pour objet de protéger le circuit d'interface contre d'éventuelles surtensions provoquées par des tensions appliquées sur la borne de sortie 0, de valeurs supérieures à la tension d'alimentation V +, ce qui est prévu dans le cahier des charges puisque le circuit d'interface doit pouvoir supporter les surtensions de + 15 V appliquées sur la borne 0, alors que la tension d'alimentation peut être relativement plus faible par exemple V + = + 8V. L'application d'une telle surtension a un amplificateur opérationnel conventionnel du genre de celui représenté à la figure 2 aurait pour effet de polariser en direct les jonctions base-collecteur des transistors T12 et T15 fonctionnant en inverse du fait de surtension et connectés selon un montage Darlington, il en résulterait une liaison à faible impédance entre la sortie et le V +. Les courants excessifs qui se développeraient alors, conduiraient à la destruction des circuits.

Pour éviter cette destruction, une diode anti-retour D1 est disposée en série dans l'alimentation V + (figure 4). Cependant, la réalisation de cette diode présente des difficultés technologiques :

— La tension de claquage émetteur-base d'un transistor NPN dont la jonction collecteur-base serait court-circuitée, qui constitue la diode normalement utilisée en circuit monolithique, est trop faible (quelques volts).

— La tension de claquage collecteur-base est meilleure mais cette jonction cause un courant de fuite vers le substrat, important qui augmente excessivement la dissipation du circuit.

Une solution originale consiste à utiliser un transistor PNP monté en diode, l'émetteur formant l'anode, la base et le collecteur sont court-circuitées et forment la cathode. Une tension de claquage satisfaisante et un courant de fuite faible, malgré une surface plus importante, caractérisent cette diode.

Cependant, l'application de surtensions positives, malgré la présence de la diode anti-retour D1, produit encore d'autres effets nuisibles. En effet, la surtension était, avant correction, transmise au V+ à travers les deux transistors T12 et T15 montés en Darlington comme mentionné ci-dessus et fonctionnant en inverse. Ils fournissaient alors un courant appréciable au substrat provoquant une dissipation indésirable non négligeable. L'action de la diode D1 peut être accrue grâce à un dispositif de dérivation (bloc IX) vers le V+. Dans une réalisation préférée, on dispose une diode de dérivation D2 qui commence à conduire à environ 0,8V, qui ne laisse pas le recul de tension nécessaire au circuit Darlington pour conduire. Cette diode de dérivation bloque en fait les transistors PNP parasites (non représentés) formés à partir des transistors T12 et T15 avec l'isolation (base, collecteur, isolation). En d'autres termes, D2 assure un court-circuit pour le courant de sortie et empêche les transistors inverses d'être polarisés en direct, bloquant ainsi tout courant vers le substrat. Cette diode peut être réalisée facilement en reliant le lit d'épitaxie dans lequel la résistance R14 est diffusée (ou implantée) à la ligne V+ du circuit.

Enfin les protections indispensables peuvent être complétées en protégeant de façon particulière les transistors T13 et T14, de type PNP. En effet, pour les transistors PNP les tensions de claquage sont souvent de valeurs inégales, les déficiences sont détectées lors du test et de nombreuses microplaquettes sont alors rejetées, ce qui conduit à de faibles rendements de fabrication. Il est donc souhaitable que les déficiences (fréquentes) en tension de claquage des transistors PNP n'aient pas une influence excessive sur le taux de rejet. Le transistor PNP de sortie T14 a été trouvé particulièrement critique du fait que le moindre courant de fuite de sa part se retrouve dans la base du transistor auxiliaire NPN de sortie T13 puis multiplié par le gain bêta (100 à 200) de ce dernier.

La solution adoptée consiste à proposer des moyens de protection (bloc X) de l'étage de sortie et plus précisément à placer un second transistor PNP T19 en parallèle sur le premier et servant de témoin de courant de fuite. Le courant de fuite de ce transistor T19 est injecté soit dans un réflecteur de courant soit directement dans la base d'un transistor NPN T20 qui agit comme réflecteur-amplificateur. Ce transistor T19 est tel que sa base est reliée soit à la borne de sortie soit à la base de T14 et de préférence T14 et T19 sont appairés.

Dans l'un ou l'autre cas, le transistor T20 a pour effet de dériver le courant de fuite supposé du PNP de sortie T14 vers le V − évitant ainsi qu'il soit injecté dans la base du transistor NPN T13 de sortie.

L'ensemble des deux transistors T19 et T20 constitue donc un circuit réflecteur anti-claquage.

B. Protection contre les surtensions négatives :

De façon similaire, il faut protéger le circuit quand la borne de sortie est portée à un potentiel plus négatif que celui de l'alimentation négative V−, par exemple − 15V, quand V − = − 8V, ou pire encore lorsque V − = 0V (circuits hors tension). Cette surtension polarise en direct la jonction base-collecteur et en inverse la jonction base-émetteur du transistor T13. Or il est connu que cette jonction claque à une tension relativement faible donnant lieu ainsi à un fort courant risquant de provoquer la destruction de ces transistors et empêchant aussi le module de satisfaire les spécifications. La solution retenue pour réaliser le circuit de protection (bloc XI, figure 4) réside cette fois encore dans l'introduction d'une diode anti-retour D3 qui bloque ainsi tout courant inverse.

L'intégration d'une telle diode est également délicate. Si on utilise la jonction émetteur-base d'un transistor NPN, la diode résultante présente une tension de claquage trop faible. Si c'est la jonction collecteur-base qui est utilisée, la diode présente une meilleure tension de claquage mais aussi l'inconvénient d'un courant de fuite notable vers le substrat. Pourtant, cette solution a été retenue mais a nécessité des moyens supplémentaires pour réduire ce dernier inconvénient et plus exactement pour en tirer avantage.

En effet, l'existence d'une surtension négative appliquée à la borne de sortie pose d'autres problèmes. Les circuits monolithiques bipolaires conventionnels (notamment les amplificateurs opérationnels) ne peuvent en général supporter sur leurs bornes de sortie une tension inférieure à la tension d'alimentation négative (V −), et ce pour une autre raison que celle du claquage des transistors de sortie (T14 dans notre cas). L'isolation entre composants étant assurée par des jonctions polarisées en inverse, obtenues en reliant le substrat de type P et les régions d'isolation de type P+ à la tension la plus négative (V −), cette isolation disparaît quand on porte la borne de sortie et donc quasi nécessairement l'une des poches épitaxiques, à un potentiel encore plus négatif.

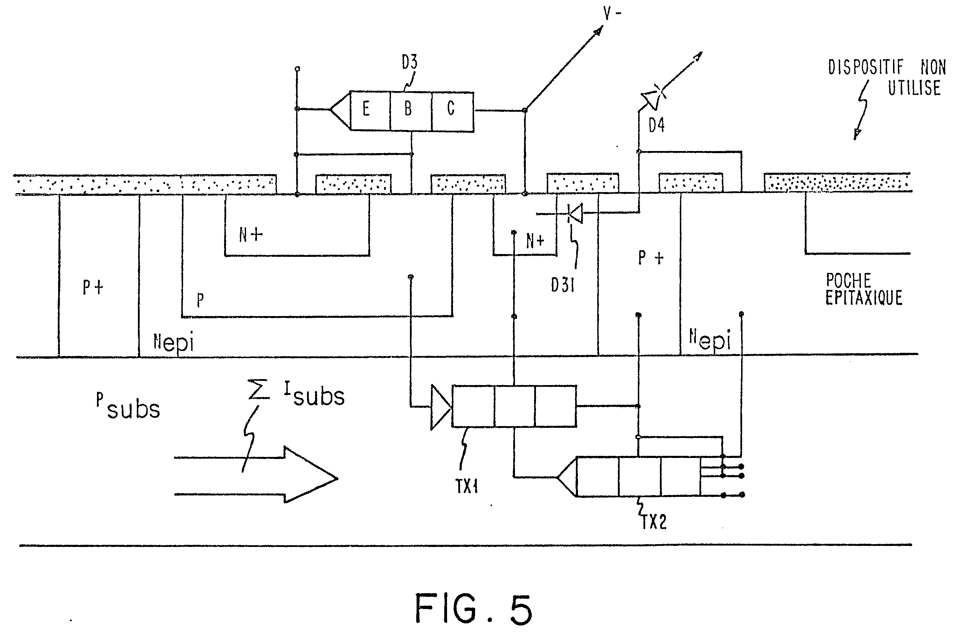

Une solution originale qui est proposée ici consiste à polariser le substrat en silicium de type P (voir la figure 5, qui montre le détail de la structure complexe qui constitue le bloc X) par « injection ». Selon cette technique on injecte des porteurs positifs au substrat, en créant volontairement dans le substrat des moyens d'injection (un transistor PNP parasite TX1), ces porteurs seront retournés ensuite au V − en fonctionnement normal par la diode D31. Ainsi le substrat trouvera de lui-même un potentiel d'équilibre (légèrement supérieur à V −). En fonctionnement normal, la somme des courants injectés dans le substrat ($\sum I_{substrat}$) est égale au courant que la diode D31 qui est reliée au V − peut passer pour cette tension.

En cas de surtension négative, la sortie est portée au potentiel − 15V par exemple alors que l'isolation était jusqu'à présent à un potentiel moins négatif (par exemple − 8V), cette surtension est transmise par la diode D4 à l'isolation, on se retrouve alors dans les conditions du cas précédent, c'est-à-dire l'isolation est quasiment au potentiel le plus négatif, ce qui est désirable. Cependant, les porteurs injectés au substrat par le PNP parasite TX1 notamment risquent de se diriger vers des circuits actifs aussi car ils vont se fixer dans des poches épitaxiques voisines de type N, qui constituent en fait les collecteurs des transistors NPN et les bases des transistors PNP supprimant ainsi le rôle d'isolation entre dispositifs du substrat et produisant des perturbations dans les circuits actifs.

Des précautions particulières ont donc été prises visant à éviter les problèmes mentionnés ci-dessus.

L'émetteur du transistor NPN formant la diode D3 a sa jonction émetteur-base court-circuitée. L'émetteur joue donc le rôle de collecteur et évite ainsi la saturation du transistor. La conséquence directe est une diminution considérable de l'injection dans le substrat.

En outre le transistor NPN formant la diode D3 est disposé dans un coin de la microplaquette, entouré d'un rideau de poches épitaxiques non utilisées pour des dispositifs actifs, lesquelles sont reliées électriquement à l'isolation (voir figure 5). En d'autres termes, ces poches jouent un rôle de collecteur dans un transistor NPN latéral TX2 constitué des éléments suivants :

Il a pour émetteur, le collecteur du transistor formant la diode D3, pour base la région d'isolation ISO et pour collecteurs (multiples) les poches épitaxiques telles que celles montrées sur la figure 5 qui sont disposées en rideau.

La base et les collecteurs de ce transistor étant reliés, ce transistor NPN n'est pas saturé car les collecteurs jouent leur rôle au maximum et capturent ainsi les porteurs négatifs injectés évitant qu'ils ne rejoignent les circuits actifs, et en les retournant par les régions d'isolation vers le V − à travers la diode D31.

## C. Polarisation du circuit

Un amplificateur opérationnel classique tel que celui représenté sur les figures 1 et 2 est polarisé par le courant produit par une résistance $R_{pol}$ disposée en série avec un transistor $T_{pol}$ entre le V+ et le V − donc, dès que les tensions d'alimentation sont appliquées.

Cette disposition présente l'inconvénient d'augmenter le courant de polarisation lorsque des surtensions sont appliquées au V+ donc à la sortie dans notre cas, ce qui n'est pas souhaitable. De plus, ceci ne permet pas de placer le circuit en position haute impédance à la mise sous tension ou en fonctionnement tristate comme cela est souhaité.

Dans l'amplificateur opérationnel modifié, la résistance $R_{pol}$ est supprimée, c'est avantageux car désormais la polarisation du circuit n'est plus soumise à la variation de tension provoquée par d'éventuelles surtensions, la liaison avec le V − également, et le collecteur du transistor $T_{pol}$ est relié directement à un circuit de commande (bloc XII). Un exemple de circuit de commande approprié est détaillé dans l'IBM TDB Bulletin, Vol. 21, No. 11, avril 1979, pages 4559 et 4560, un article intitulé : « Logic Interface Module » par F. Delaporte et J.P. Pantani. Ainsi, le courant de polarisation des différents étages du circuit (blocs I à VI) est constant et indépendant des surtensions, de plus il peut être coupé en cas de nécessité.

## D. Ajustage de la pente

On a vu que l'ajustage de la pente dans les circuits d'interface traditionnels tels que ceux mentionnés ci-dessus s'effectuait par un condensateur extérieur, ce qui présente de nombreux inconvénients :

La charge et la décharge de ce condensateur absorbent un courant important et causent une dissipation élevée. Aussi il est reconnu avec ces circuits, en raison de variations causées par le procédé de fabrication, que la pente est très mal définie. D'où de très larges variations des temps de commande en courant du circuit : par exemple, de 0,2 à 2 microsecondes pour passer de − 3 à + 3V pour un circuit de l'art antérieur (SN 75150) chargé par 2 500 picofarads. La longueur du câble et sa capacité ajoutent encore à cette incertitude.

Par ailleurs, on a vu que l'amplificateur opérationnel classique comportait un condensateur C utilisé à des fins de correction de fréquence, ce condensateur peut être parfaitement mis en œuvre dans le présent circuit d'interface.

Disposé non sur un circuit de sortie à faible impédance mais dans un circuit interne à forte impédance et mettant à profit l'effet Miller, sa valeur peut être rendue faible ; il est donc facilement intégrable, sa valeur est fixe et adaptée aux circuits voisins et aux besoins définis une fois pour toute par les normes, assurant une valeur de pente bien déterminée, totalement indépendante de la charge de sortie. Le rôle de ce condensateur est donc différent de celui qu'il joue dans un amplificateur opérationnel, c'est pourquoi la référence II' est utilisée sur la figure 3.

Bien que l'on ait décrit dans ce qui précède et représenté sur les dessins les caractéristiques essentielles de l'invention appliquées à un mode de réalisation préféré de celle-ci, il est évident que l'homme de l'art peut y apporter certaines modifications de forme ou de détail qu'il juge utiles, sans pour autant sortir du cadre de ladite invention. En particulier toutes les zones dites P pourraient être N et vice versa si le matériau de départ était de type N ; également le semiconducteur pourrait être d'un autre matériau que le silicium ; certains éléments de cette invention subsisteraient aussi si la réalisation était de type discrète ou hybride ou si l'isolation entre dispositifs était obtenue par d'autres techniques que le procédé Planar utilisé ici (air, diélectrique ou SOS).

## Revendications

1. Circuit d'interface numérique intégré monolithique mettant en œuvre un amplificateur opérationnel du genre comportant :

Un convertisseur différentiel d'entrée (I) ayant deux bornes d'entrée E⁻, E⁺ ; un circuit correcteur de fréquences (II) ; un amplificateur de tension (III) couplé audit circuit correcteur de fréquences et à des étages suiveurs positif (IV) et négatif (V), ces derniers étant couplés à travers un étage limiteur de courant (VI), à une borne de sortie (0) ; et un circuit de polarisation (VII) ; caractérisé en ce que la borne d'entrée E⁺ du convertisseur différentiel d'entrée (I) est reliée à une tension de référence $V_{ref}$ ; en ce qu'il comporte une pluralité de moyens de protection comprenant des premiers moyens de protection à conduction unidirectionnelle (VIII) montés en série avec la source d'alimentation V⁺ pour protéger les différents étages de l'amplificateur opérationnel des surtensions positives susceptibles de se produire sur la borne de sortie (0) ; en ce qu'il comporte des seconds moyens de protection (IX) à conduction unidirectionnelle couplés entre ladite borne de sortie (0) et lesdits premiers moyens de protection, pour protéger l'étage suiveur positif (IV) et l'étage limiteur de courant (VI) contre les surtensions positives ; des troisièmes moyens de protection (X) de l'étage suiveur négatif (V) ; et des quatrièmes moyens de protection (XI) montés en série avec la source d'alimentation V⁻, pour protéger l'étage suiveur négatif (V), l'amplificateur en tension (III) et le convertisseur différentiel d'entrée (I) contre les surtensions négatives.

2. Circuit d'interface selon la revendication 1 caractérisé en ce que lesdits premiers moyens de protection (VIII) à conduction unidirectionnelle sont constitués par une diode anti-retour (D1).

3. Circuit d'interface selon la revendication 2 caractérisé en ce que cette diode anti-retour (D1) est réalisée à partir d'un transistor PNP latéral dont la région d'émetteur constitue l'anode, et dont les régions base et collecteur court-circuitées constituent la cathode.

4. Circuit d'interface selon l'une des revendications 1 à 3 caractérisé en ce que lesdits seconds moyens de protection (IX) à conduction unidirectionnelle sont constitués par une diode (D2) disposée entre la borne de sortie (0) et le V+.

5. Circuit d'interface selon la revendication 4 caractérisé en ce que la diode (D2) est réalisée par la jonction PN formée entre une résistance (R14), dont la région de type P est reliée à la borne de sortie, et le lit épitaxique porté au potentiel du V+.

6. Circuit d'interface selon l'une des revendications 1 à 5 caractérisé en ce que lesdits quatrièmes moyens de protection sont constitués par une diode anti-retour (D3).

7. Circuit d'interface selon la revendication 6 caractérisé en ce que cette diode anti-retour (D3) est réalisée à partir d'un transistor NPN dont la région d'émetteur constitue la cathode et dont les régions base et collecteur court-circuitées constituent l'anode.

8. Circuit d'interface selon l'une des revendications ci-dessus caractérisé en ce que lesdits troisièmes moyens de protection (X) consistent essentiellement dans un circuit réflecteur de courant anti-claquage.

9. Circuit d'interface selon l'une des revendications ci-dessus caractérisé en ce qu'il comporte en outre des moyens de commande et de contrôle (XII) couplés audit circuit de polarisation, qui permet de couper la transmission de données et/ou de placer le circuit dans un état haut impédance.

**Claims**

1. Digital monolithic integrated interface circuit implementing an operational amplifier which includes :

an input differential converter (I) with two input terminals E⁻, E⁺ ; a frequency correcting circuit (II) ; a voltage amplifier (III) coupled to said frequency correcting circuit and to positive and negative follower stages (IV) and (V), the latter being coupled to an output terminal through a current limiter stage (VI) ; as well as a biasing circuit (VII), characterized in that the input terminal R⁺ of the input differential converter (I) is connected to a reference voltage (V_ref), and that it is provided with a plurality of protection means with first unidirectionally conducting protective means (VIII) being series-mounted to the voltage source V⁺ so as to prevent the various stages of the operational amplifier from positive overvoltages which may occur at the output terminal (0) ; and in that it includes second unidirectionally conducting protective means (IX) coupled between said output terminal (0) and said first protective means so as to prevent said positive follower stage (IV) and said current limiter stage (VI) from positive overvoltages ; third protective means (X) for the negative follower stage (V) ; and fourth protective means (IV), which are series-mounted to a voltage source V⁻, so as to prevent said negative follower stage (V), said voltage amplifier (III) and said input differential converter (I) from negative overvoltages.

2. Interface circuit according to claim 1, characterized in that said unidirectionally conducting first positive means (VIII) are comprised of a blocking diode (D1).

3. Interface circuit according to claim 2, characterized in that said blocking diode (D1) is a lateral PNP transistor the emitter zone of which is its anode, and the shorted out base and collector zones of which are its cathode.

4. Interface circuit according to claims 1 to 3, characterized in that said second unidirectionally conducting protective means (IX) is a diode (D2) arranged between the output terminal (0) and V⁺.

5. Interface circuit according to claim 4, characterized in that the diode (D2) is formed of the PN junction generated between a resistance (R14) the P zone of which being connected to said output terminal and epitaxial bed grown to potential V⁺.

6. Interface circuit according to any one of claims 1 to 5, characterized in that said fourth protective means comprises a blocking diode (D3).

7. Interface circuit according to claim 6, characterized in that said blocking diode (D3) is formed of a NPN transistor the emitter zone of which is the cathode and the shorted out base and collector zones of which constitute the anode.

8. Interface circuit according to one of above claims, characterized in that said third protective means (X) are essentially comprised of an anti-breakdown current mirror circuit.

9. Interface circuit according to one of above claims, characterized in that it additionally includes drive and control means (XII) coupled to said biaising circuit for stopping the transmission of data and/or putting the circuit into a high impedance condition.

**Ansprüche**

1. Digitale monolithisch integrierte Schnittstellenschaltung mit einem Operationsverstärker, der aufweist :

einen Eingangs-Differenzwandler (I) mit zwei Eingangsklemmen E⁻ und E⁺, eine Frequenz-Korrekturschaltung (II), einen mit dieser Frequenz-Korrekturschaltung sowie mit einer positiven und einer negativen Spannungsfolgerstufe (IV, V) verbundenen Spannungsverstärker (III), wobei die letzteren mit einer Ausgangs-

klemme (O) über eine Strombegrenzungsstufe (VI) gekoppelt sind, sowie eine Vorspannungsschaltung (VIII), dadurch gekennzeichnet, daß die Eingangsklemme $E^+$ des Eingangs-Differenzwandlers mit einer Referenzspannung (Vref) verbunden ist, daß er zum Schutz der Operationsverstärkerstufen gegen evtl. an der Ausgangsklemme (O) auftretende positive Überspannungen eine Vielzahl von gegenüber der Spannungsquelle $V^+$ hintereinandergeschalteten und in einer Stromflußrichtung wirksamen Schutzvorrichtungen (VIII) aufweist, daß er zum Schutz der positiven Spannungsfolgerstufe (IV) und der Strombegrenzungsstufe (VI) gegen die positiven Überspannungen zweite, in einer Stromflußrichtung wirksame Schutzvorrichtungen (IX) aufweist, die zwischen die genannte Ausgangsklemme (O) und die genannten ersten Schutzvorrichtungen geschaltet sind, sowie dritte Schutzvorrichtungen (X) zum Schutz der negativen Spannungsfolgerstufe (V) und vierte, der Spannungsquelle $V^-$ gegenüber in Serie geschaltete Schutzvorrichtungen (XI) zum Schutz der negativen Spannungsfolgerstufe (V), des Spannungsverstärkers (III) und des Eingangs-Differenzwandlers (I) gegen die negativen Überspannungen.

2. Schnittstellenschaltung nach Anspruch 1, dadurch gekennzeichnet, daß die genannten ersten, in einer Stromflußrichtung wirksamen Schutzvorrichtungen (VIII) aus einer Sperrdiode (D1) bestehen.

3. Schnittstellenschaltung nach Anspruch 2, dadurch gekennzeichnet, daß die Sperrdiode (D1) mit einem lateralen PNP-Transistor ausgeführt ist, dessen Emitterzone die Anode ist und dessen kurzgeschlossene Basis- und Kollektorzonen die Kathode bilden.

4. Schnittstellenschaltung nach einem der Ansprüche 1 bis 3, dadurch gekennzeichnet, daß die genannten zweiten, in einer Stromflußrichtung wirksamen Schutzvorrichtungen (IX) aus einer zwischen die Ausgangsklemme (O) und $V^+$ geschalteten Diode (D2) bestehen.

5. Schnittstellenschaltung nach Anspruch 4, dadurch gekennzeichnet, daß die Diode (D2) durch einen PN-Übergang ausgeführt ist, der zwischen einem mit der Ausgangsklemme durch seine P-Leitungszone verbundenen Widerstand (R14) und dem auf dem Potential $V^+$ gehaltenen Epitaxialbett gebildet ist.

6. Schnittstellenschaltung nach einem der Ansprüche 1 bis 5, dadurch gekennzeichnet, daß die vierten Schutzvorrichtungen aus einer Sperrdiode (D3) bestehen.

7. Schnittstellenschaltung nach Anspruch 6, dadurch gekennzeichnet, daß diese letzte Sperrdiode (D3) mit einem NPN-Transistor ausgeführt ist, dessen Emitterzone die Kathode bildet, und dessen kurzgeschlossene Basis- und Kollektorzonen die Anode bilden.

8. Schnittstellenschaltung nach einem der vorhergehenden Ansprüche, dadurch gekennzeichnet, daß die genannten dritten Schutzvorrichtungen (X) im wesentlichen aus einer Stromspiegelschaltung zur Verhinderung von Spannungsdurchbrüchen bestehen.

9. Schnittstellenschaltung nach einem der vorhergehenden Ansprüche, dadurch gekennzeichnet, daß sie mit der Vorspannungsschaltung gekoppelte Steuer- und Prüfmittel (XII) aufweist, um die Datenübertragung zu unterbrechen und/oder die Schnittstellenschaltung in einen Zustand hohen Widerstandes zu versetzen.

FIG. 1

0 029 919

FIG. 2

0 029 919

FIG. 3

0 029 919

FIG. 4

0 029 919

FIG. 5

DISPOSITIF NON UTILISE

POCHE EPITAXIQUE

0 029 919